# EUROPEAN PATENT APPLICATION

(11) **EP 4 333 043 A1**
(43) Date of publication of application: **06.03.2024**
(21) Application number: 22795262.9
(22) Date of filing: 25.02.2022
(51) Int. Cl.: H01L 23/02, H01S 5/0222, H01S 5/0233, H01S 5/024

(54) **LIGHT SOURCE DEVICE**

(30) Priority: 27.04.2021 JP 2021074735; 17.09.2021 JP 2021151993
(71) Applicant: Nichia Corporation, Anan-shi, Tokushima 774-8601 (JP)
(72) Inventor: MIYATA, Tadaaki, Anan-shi, Tokushima 774-8601 (JP)
(74) Representative: Betten & Resch
(86) International application number: PCT/JP2022/007833
(87) International publication number: WO 2022/230339

(57) **Abstract**

Alight source device (100) is provided with: a substrate (10) having a support surface (10A); a first sub-mount (20) having a first upper surface (20A) and a first mounting surface (20B) opposing the support surface (10A); one or more laser diodes (30) positioned between the substrate (10) and the first sub-mount (20) and having a p-side electrode surface (30B) and an n-side electrode surface (30A); a side wall section (15) provided on the substrate (10), having a second upper surface (15A) and an inner wall surface (15C), and defining by the inner wall surface (15C) a space (V) in which the laser diode (30) is housed; a heat dissipation member (60) provided on the first sub-mount (20); and a metal member (50) joined to the heat dissipation member (60) and the second upper surface (15A) to seal the space (V). The height from the support surface (10A) to the first upper surface (20A) is different from the height from the support surface (10A) to the second upper surface (15A). One of the p-side electrode surface (30B) and then-side electrode surface (30A) is directly or indirectly joined to the support surface (10A). The other of the p-side electrode surface (30B) and the n-side electrode surface (30A) is joined to the first mounting surface (20B).

## Description

### BACKGROUND

### Technical Field

The present disclosure relates to a light source device.

### Background Art

Light-emitting devices have been developed that are provided with a sealing structure that seals a space inside a package in which a laser diode is housed. Patent Document 1 discloses a light-emitting device provided with an upper substrate, a lower substrate facing the upper substrate, a submount supporting a laser diode, and a wavelength converter. In this light-emitting device, the laser diode is disposed between the upper substrate and the lower substrate to which the submount is bonded. A space for sealing the laser diode is formed via the wavelength converter.

### Citation List

### Patent Literature

Patent Document 1: JP 2016-167492 A

### SUMMARY OF INVENTION

### Technical Problem

According to embodiments of the present disclosure, a novel sealing structure for hermetically sealing a space, in which a laser diode is housed, inside a package is provided.

### Solution to Problem

According to a non-limiting, exemplary embodiment, a light source device according to the present disclosure includes a substrate having a support surface; a first submount including a first mounting surface that faces the support surface, and a first upper surface located on a side opposite to the first mounting surface; one or more laser diodes located between the substrate and the first submount and including a p-side electrode surface and an n-side electrode surface located on a side opposite to the p-side electrode surface; a lateral wall portion on the substrate, the lateral wall portion having a second upper surface and an inner wall surface, the inner wall surface defining a space in which the laser diode is housed; a heat dissipation member disposed on the first submount; and a metal member bonded to the heat dissipation member and the second upper surface and sealing the space. A height from the support surface to the first upper surface is different from a height from the support surface to the second upper surface. One of the p-side electrode surface or the n-side electrode surface is directly or indirectly bonded to the support surface, and the other of the p-side electrode surface or the n-side electrode surface is bonded to the first mounting surface.

### Advantageous Effects of Invention

According to an exemplary embodiment of the present disclosure, a novel sealing structure for hermetically sealing a space, in which a laser diode is housed, inside a package is provided.

### BRIEF DESCRIPTION OF DRAWINGS

FIG. 1 is a cross-sectional view parallel to the YZ plane of a light source device according to a first embodiment of the present disclosure.
FIG. 2 is a cross-sectional view parallel to the XY plane of the light source device according to the first embodiment of the present disclosure.
FIG. 3 is a plan view of the light source device according to the first embodiment of the present disclosure in a top plan view as seen in a direction normal to a support surface of a substrate.
FIG. 4 is a cross-sectional view parallel to the YZ plane of the light source device according to a first embodiment of the present disclosure with external connection electrodes provided on the support surface of the substrate.
FIG. 5 is a cross-sectional view parallel to the YZ plane of another configuration example of the light source device according to the first embodiment of the present disclosure.
FIG. 6 is a cross-sectional view parallel to the YZ plane of yet another configuration example of the light source device according to the first embodiment of the present disclosure.
FIG. 7 is a cross-sectional view parallel to the YZ plane of the light source device according to a first embodiment of the present disclosure further including a heat dissipation member.
FIG. 8 is a cross-sectional view parallel to the XY plane of the light source device according to the first embodiment of the present disclosure including a plurality of laser diodes.
FIG. 9 is a cross-sectional view parallel to the YZ plane of a modified example of the light source device according to the first embodiment of the present disclosure.
FIG. 10 is a cross-sectional view parallel to the XY plane of the modified example of the light source device according to the first embodiment of the present disclosure.
FIG. 11 is a plan view of the modified example of the light source device according to the first embodiment of the present disclosure in a top plan view as seen in the direction normal to the support surface of the substrate.
FIG. 12 is a cross-sectional view parallel to the YZ plane of another modified example of the light source device according to the first embodiment of the present disclosure.
FIG. 13 is a cross-sectional view parallel to the YZ plane of yet another modified example of the light source device according to the first embodiment of the present disclosure.
FIG. 14 is a cross-sectional view parallel to the YZ plane of yet another modified example of the light source device according to the first embodiment of the present disclosure.
FIG. 15 is a plan view of a pressing member in a top plan view as seen in the direction normal to the support surface of the substrate.
FIG. 16 is a cross-sectional view parallel to the YZ plane of yet another modified example of the light source device according to the first embodiment of the present disclosure.
FIG. 17 is a plan view of a metal member in a top plan view as seen in the direction normal to the support surface of the substrate.
FIG. 18 is a cross-sectional view parallel to the YZ plane of yet another modified example of the light source device according to the first embodiment of the present disclosure.
FIG. 19 is a plan view of a metal member according to another example in a top plan view as seen in the direction normal to the support surface of the substrate.
FIG. 20 is a cross-sectional view parallel to the XY plane of a light source device according to a second embodiment of the present disclosure.
FIG. 21 is a plan view of a second submount in a state of supporting two laser diodes, two conductive members, and a support member in a top plan view as seen in the direction normal to the support surface of the substrate.

### DETAILED DESCRIPTION OF EMBODIMENTS

Embodiments of the present disclosure are described below in detail with reference to the drawings. The following embodiments are examples, and the light source device according to the present disclosure is not limited to the following embodiments. Numerical values, shapes, materials, steps, order of steps, and the like described in the following embodiments are merely examples, and various modifications can be made as long as a technical contradiction does not arise. The various modes described below are merely examples, and various combinations can be made as long as a technical contradiction does not arise.

The dimensions, shapes, and the like of components illustrated in the drawings may be exaggerated to facilitate understanding and need not reflect the dimensions, shapes, and size relationships between components in an actual light source device. Furthermore, in order to avoid excessive complication of the drawings, illustration of some components may be omitted.

In the following description, components having substantially the same function may be denoted by the same reference signs and a description thereof may be omitted. Terms indicating a specific direction or position (for example, "upper", "lower", "right", "left", and other terms including those terms) may be used. However, these terms are used merely to facilitate understanding of relative directions or positions in the referenced drawing. In drawings other than the drawings of the present disclosure, actual products, manufacturing devices, and the like, components is not necessarily in the same arrangement as that in the referenced drawing, as long as the relative direction or position is the same as that described in the referenced drawing using the term such as "upper" or "lower."

In this specification or the claims, a polygon such as a triangle and a quadrangle is not limited to a polygon in a mathematically strict sense and also includes a shape in which corners of the polygon are processed to be rounded, chamfered, beveled, coved, or the like. Not only a shape with a modification only at a corner (an end of a side) of a polygon but also a shape with a modification at an intermediate portion of a side is also referred to as a polygon. That is, a polygon-based shape with a partial modification is encompassed in the meaning of "polygon."

In this specification or the scope of the claims, when there are a plurality of components identified by a specific term and the components are to be distinguished from each other an ordinal number such as "first" and "second" may be added before each of the terms of the components. These ordinal numbers are merely labels for distinguishing objects to which the ordinal numbers are added. The number, sequence, order, and the like of these have no special meaning. For example, in claim 1 described in the claims, when the term "first submount" is used and the term "second submount" is not used, the invention according to claim 1 sufficiently include one submount, and the light-emitting element is not limited to refer to the "first submount" in the specification and the submount may refer to the "second submount" in the specification.

### First Embodiment

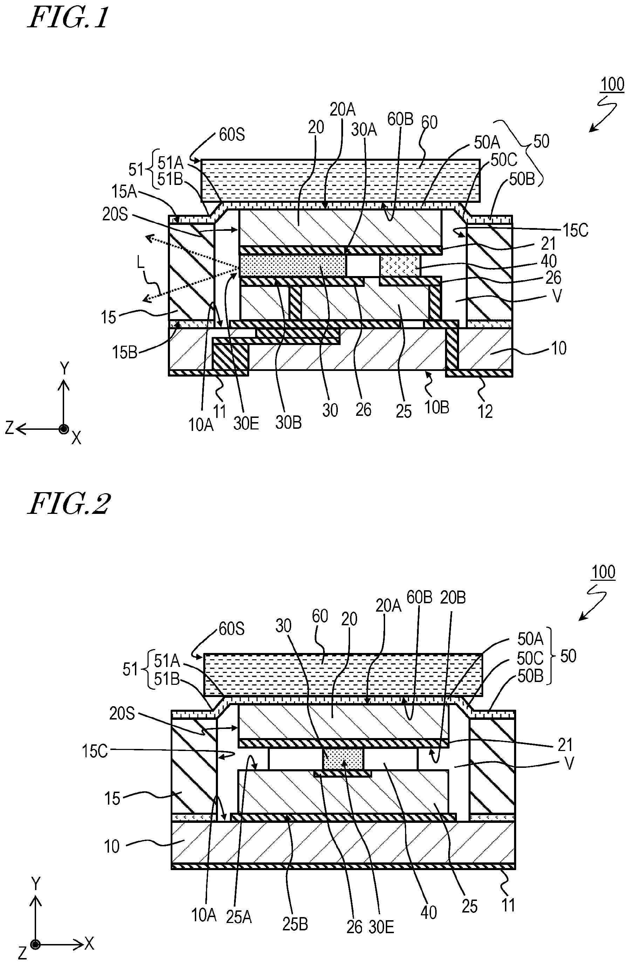

An example of the configuration of a light source device 100 according to the first embodiment of the present disclosure will be described with reference to FIGS. 1 to 3. An X-axis, a Y-axis, and a Z-axis that are orthogonal to each other in the drawings are illustrated for reference.

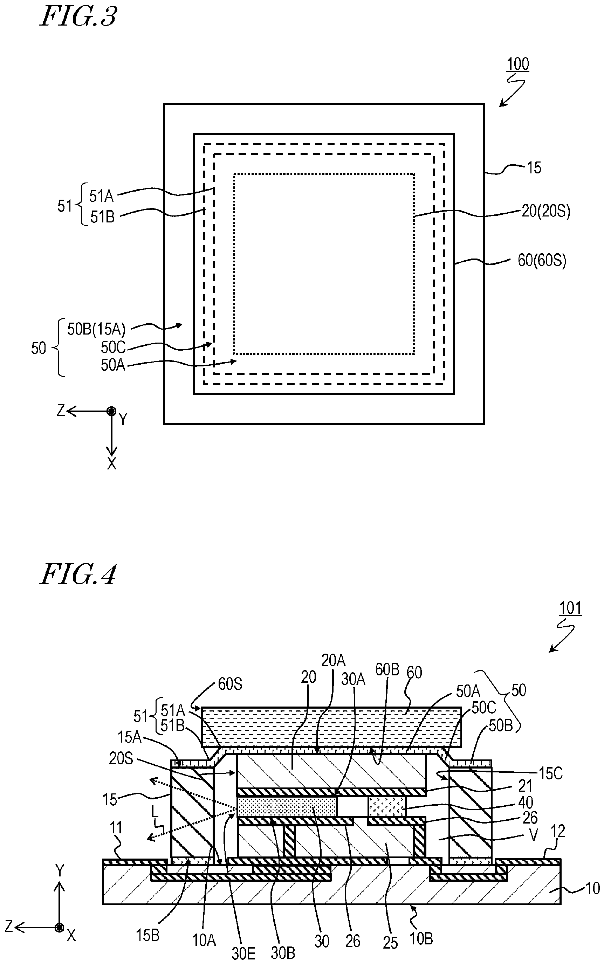

FIG. 1 is a cross-sectional view parallel to the YZ plane of the light source device 100. The cross section illustrated in FIG. 1 includes the cross section of a laser diode 30 and a conductive member 40. A laser light L emitted from an emission end surface 30E of the laser diode 30 in the Z-direction is indicated by a dashed line. FIG. 2 is a cross-sectional view parallel to the XY plane of the light source device 100. The cross section illustrated in FIG. 2 includes the emission end surface 30E of the laser diode 30. FIG. 3 is a plan view of the light source device 100 in a top plan view as seen in the direction normal to a support surface 10A of a substrate 10.

The light source device 100 according to the present embodiment includes the substrate 10, a first submount 20, a second submount 25, one or more laser diodes 30, the conductive member 40, a metal member 50, and a heat dissipation member 60. In the example illustrated in FIGS. 1 and 2, the light source device 100 includes one laser diode 30. However, as described below, the light source device 100 may include a plurality of laser diodes 30. Depending on the product specifications or requested specifications, the light source device 100 may include a protective element represented by a Zener diode and/or a temperature sensor for measuring the internal temperature, such as a thermistor. Further, the light source device 100 may include a light receiving element, such as a photodiode, for monitoring the intensity of the laser light L emitted from the laser diode 30.

As illustrated in FIG. 3, the light source device 100 has a quadrangular shape in a top plan view as seen in the direction normal to the support surface 10A of the substrate 10, that is, in the Y-direction. However, the shape of the light source device is not limited thereto. In FIGS. 1 to 3, the direction normal to the support surface 10A coincides with the Y-direction. In the following description, the phrase "top plan view" refers to a top plan view viewed in a direction normal to the support surface 10A, that is, in the Y-direction. For example, the size of the light source device 100 in the X-direction is approximately in a range of 1.0 mm to 30.0 mm, and the size in the Z-direction is approximately in a range of 1.0 mm to 5.0 mm. The thickness of the thickest portion of the light source device 100 in the Y-direction may be approximately in a range of 1.0 mm to 3.0 mm.

The substrate 10 according to the present embodiment is a plate-like member. The substrate 10 has the support surface 10A that directly or indirectly supports the laser diode 30, and a lower surface 10B located on a side opposite to the support surface 10A. A metal film of gold or the like may be formed on the support surface 10A of the substrate 10, for bonding with other members, such as a lateral wall portion 15 and the second submount 25. The substrate 10 can be formed using a ceramic, a metal, silicone, a resin, or the like as a main material. For example, in a case in which a ceramic is used, aluminum nitride, silicon nitride, aluminum oxide, silicon, silicon carbide, or the like can be used as a main material of the substrate. In a case in which a metal is used, copper, aluminum, iron, or composites such as copper molybdenum, a copper-diamond composite material, copper tungsten, and the like can be used as a main material of the substrate. However, in a case in which a metal is used, insulating treatment is required for the support surface 10A and the lower surface 10B in order to provide a conductive wiring layer on the substrate. Alternatively, a portion directly below the laser diode 30 may be formed of a metal and the other portions may be formed of a ceramic.

The substrate 10 includes conductive wiring layers and external connection electrodes electrically connected to the laser diode 30. The conductive wiring layers and the external connection electrodes may be formed of a metal material such as tungsten, molybdenum, nickel, gold, silver, platinum, titanium, copper, aluminum, ruthenium, or the like, for example. The conductive wiring layers may be provided on the support surface 10A of the substrate 10 and inside the substrate 10, and an external connection electrode 11 and an external connection electrode 12 may be provided on the lower surface 10B of the substrate 10. The conductive wiring layer provided on the support surface 10A and the external connection electrode 11 and the external connection electrode 12 provided on the lower surface 10B are electrically connected via the conductive wiring layer and a via hole provided inside the substrate 10.

The external connection electrode 11 is electrically connected to one of a p-side electrode surface or an n-side electrode surface of the laser diode 30. The external connection electrode 12 is electrically connected to the other of the p-side electrode surface or the n-side electrode surface of the laser diode 30. For example, an external power supply or an external drive circuit for driving the laser diode 30 can be electrically connected to the laser diode 30 via the external connection electrode 11 and the external connection electrode 12. The external connection electrode 11 and the external connection electrode 12 do not need to be provided on the lower surface 10B as illustrated in FIG. 1 and may be provided on the support surface 10A, for example.

FIG. 4 is a cross-sectional view parallel to the YZ plane of the light source device 101 in which the external connection electrode 11 and the external connection electrode 12 are provided on the support surface 10A. The external connection electrode 11 and/or the external connection electrode 12 can be provided on the support surface 10A. As illustrated in FIG. 4, the size of the substrate 10 in a top plan view may be larger than the size of the lateral wall portion 15, and the external connection electrode 11 and the external connection electrode 12 may be provided in a region outside the lateral wall portion 15 on the support surface 10A.

The lateral wall portion 15 is provided surrounding the laser diode 30 and is bonded to the support surface 10A. The lateral wall portion 15 includes a second upper surface 15A, a lower surface 15B, and an inner wall surface 15C. The inner wall surface 15C surrounds the laser diode 30 and defines a space V in which the laser diode 30 is housed. The lower surface 15B of the lateral wall portion 15 is bonded to the support surface 10A of the substrate 10. This bonding may be implemented through a bonding portion formed from an inorganic or organic material. The bonding portion may be formed by, for example, sintering, brazing, soldering, ultrasonic welding, resistance welding, laser welding, or the like. As the material of the bonding portion, for example, a metal such as gold-tin or a solder alloy, a metal paste such as a gold paste or a silver paste, or a metal foil can be used. However, in a case in which a laser diode configured to emit blue or green light is used, use of an organic material is preferably avoided in consideration of effect of dust attraction caused by the laser light.

The lateral wall portion 15 is disposed, on the support surface 10A, at a position that intersects the laser light L emitted from the laser diode 30, and transmits the laser light L. In the lateral wall portion 15, at least a portion that transmits the laser light L may be formed of a material such as alkali glass, alkali-free glass, sapphire, phosphor-containing glass, a transparent ceramic material, or the like. "Alkali glass" is silicate compound glass containing mobile ions of an alkali metal element, such as Na⁺, Ka⁺, Li⁺, or the like. Silicate compound glass having an alkali oxide concentration of 0.1 mass% or less is referred to as "alkali-free glass." Examples of the silicate compound glass include silicate glass, borosilicate glass, and quartz glass. A portion of the lateral wall portion 15 that does not transmit the laser light L may be formed of, for example, silicon, glass, a ceramic, or the same material as that of the substrate 10 described above.

In the present embodiment, the substrate 10 and the lateral wall portion 15 are members separate from each other. These members, the substrate 10 and the lateral wall portion 15, may be collectively referred to as a "package". In the package, the substrate 10 and the lateral wall portion 15 may be integrally formed.

The laser diode 30 includes a p-side electrode, an n-side electrode, and a semiconductor multilayer structure including a p-side semiconductor layer, an n-side semiconductor layer, and an active layer located between these layers. When a voltage is applied to the p-side electrode and the n-side electrode to cause a current to flow inside, the laser light L is emitted from the emission end surface 30E of the laser diode 30. The laser diode 30 according to the present embodiment is of an edge-emitting type having the emission end surface 30E from which the laser light L is emitted. The laser diode 30 may have a plurality of light-emitting points.

In the present embodiment, the surface of the n-side electrode is referred to as an "n-side electrode surface 30A", and the surface of the p-side electrode is referred to as a "p-side electrode surface 30B". The laser diode 30 has the p-side electrode surface 30B and the n-side electrode surface 30A located on a side opposite to the p-side electrode surface 30B.

As the laser diode 30, for example, a laser diode configured to emit blue light, a laser diode configured to emit green light, a laser diode configured to emit red light, or the like can be used. In addition, a laser diode that emits light other than visible light, for example, near infrared light or ultraviolet light, may be used.

In this specification, blue light is light having an emission peak wavelength within a range of 420 nm to 494 nm. Green light is light having an emission peak wavelength within a range of 495 nm to 570 nm. Red light is light having an emission peak wavelength within a range of 605 nm to 750 nm.

Examples of the laser diode configured to emit blue light or the laser diode configured to emit green light include a laser diode containing a nitride semiconductor. For example, GaN, InGaN, or AlGaN can be used as the nitride semiconductor. Examples of the laser diode configured to emit red light include a laser diode containing an InAlGaP-based, GaInP-based, GaAs-based, or AlGaAs-based semiconductor.

The laser light emitted from the laser diode diverges in the fast axis direction and the slow axis direction and exhibits a far field pattern (hereinafter referred to as an "FFP") of an elliptical shape in a plane parallel to the emission end surface of the laser light. Laser light divergence is greater in the fast axis direction than in the slow axis direction. The FFP is defined by the light intensity distribution of the laser light at a position away from the emission end surface. Based on the light intensity distribution, a portion having an intensity of 1/e² or greater with respect to a peak intensity value may be referred to as a beam cross section. In the example illustrated in FIG. 1, the optical axis of the laser light L emitted from the laser diode 30 is parallel to the Z-direction. The fast axis direction and the slow axis direction are parallel to the X-direction and the Y-direction, respectively. The term "parallel" used here has a tolerance of ±5 degrees. However, the optical axis of the laser light L need not be parallel to the Z-direction.

As illustrated in FIG. 1, the laser light L is emitted from the emission end surface 30E of the laser diode 30, and then diverges and spreads in the fast axis direction, that is, the Y-direction. Thus, the laser light L is preferably collimated or made to converge by an optical system including a lens. Such an optical system may be provided inside or outside the light source device 100.

Each of the first submount 20 and the second submount 25 is a heat dissipation member and typically has a rectangular parallelepiped shape. The submounts may have other appropriate shape. Each submount functions to dissipate heat generated by the laser diode 30. In order to further improve heat dissipation, each submount is preferably formed of a material having a higher thermal conductivity than the laser diode 30. For example, a ceramic material such as aluminum nitride, silicon nitride, aluminum oxide, or silicon carbide; a metal material such as copper, aluminum, silver, iron, nickel, molybdenum, tungsten, or copper-molybdenum; diamond; or the like is used as the material.

As illustrated in FIG. 2, the first submount 20 includes a first mounting surface 20B facing the support surface 10A of the substrate 10 and a first upper surface 20A located on a side opposite to the first mounting surface 20B. The first submount 20 includes a first wiring layer 21 electrically connected to the laser diode 30 and located at the first mounting surface 20B. In the example illustrated in FIGS. 1 and 2, the n-side electrode surface 30A of the laser diode 30 is bonded to the first wiring layer 21. Thus, the laser diode 30 is in thermal contact with and electrically connected to the first submount 20. As used herein, the meaning of the term "thermal contact" encompasses not only the electrode surface being in indirect contact with the submount via a solid conductive member, but also the electrode surface being in direct contact with the submount.

The n-side electrode surface 30A of the laser diode 30 and the first wiring layer 21 can be bonded to each other via a bonding member. The bonding member is, for example, a metal bump containing a metal such as gold, silver, copper, aluminum, gold-tin, or a solder or a metal paste containing a metal with electrical conductivity such as gold or gold-tin. The n-side electrode surface 30A can be bonded to the first wiring layer 21 using these materials. The "bonding portion" described below may be formed of a bonding member as described above unless otherwise specified.

As illustrated in FIG. 2, the second submount 25 has a lower surface 25B bonded to the support surface 10A and a second mounting surface 25A located on the opposite side to the lower surface 25B. The second mounting surface 25A faces the first mounting surface 20B of the first submount 20. The second submount 25 includes a second wiring layer 26 electrically connected to the laser diode 30 and located at the second mounting surface 25A. The lower surface 25B may be bonded to the support surface 10A of the substrate 10 via a bonding portion.

The laser diode 30 is disposed on the second mounting surface 25A of the second submount 25. A via hole may be formed in the second submount 25. In the example illustrated in FIGS. 1 and 2, the laser diode 30 is bonded to the support surface 10A via the second submount 25. More specifically, the p-side electrode surface 30B of the laser diode 30 may be bonded to the second wiring layer 26 via a bonding portion. The p-side electrode surface 30B is electrically connected to the conductive wiring layer of the substrate 10 through a via hole that electrically connects the second wiring layer 26 and the conductive wiring layer provided on the lower surface 25B of the second submount 25.

The first submount 20 and the second submount 25 are disposed with the laser diode 30 disposed therebetween. When the laser diode 30 is disposed between the pair of submounts, the heat generated by the laser diode 30 can be efficiently released to the first submount 20 and the second submount 25. The heat dissipation effect may be further improved by setting the thickness of the laser diode 30 to approximately a few µm.

In the example of the light source device 100 illustrated in FIGS. 1 and 2, the size of the first submount 20 is equal to the size of the second submount 25. However, the size of the first submount 20 may be different from the size of the second submount 25. For example, in a top plan view, the first submount 20 may enclose the second submount 25, or conversely, the second submount 25 may enclose the first submount 20. The first submount 20 may be thicker or thinner than the second submount 25 in the Y-direction.

As described above, the n-side electrode surface 30A of the laser diode 30 is bonded to the first wiring layer 21 of the first submount 20. The p-side electrode surface 30B is bonded to the second wiring layer 26 of the second submount 25. Alternatively, with the n-side electrode surface 30A and the p-side electrode surface 30B vertically inverted, the n-side electrode surface 30A may be bonded to the second wiring layer 26, and the p-side electrode surface 30B may be bonded to the first wiring layer 21.

One of the p-side electrode surface 30B or the n-side electrode surface 30A of the laser diode 30 may be bonded to the support surface 10A of the substrate 10, and the other one of the p-side electrode surface 30B or the n-side electrode surface 30A may be bonded to the first mounting surface 20B of the first submount 20. As used herein, the expression "one of the p-side electrode surface 30B or the n-side electrode surface 30A is bonded to the support surface 10A" means that one of these surfaces are directly or indirectly bonded to the support surface 10A. In the present embodiment, the p-side electrode surface 30B is indirectly bonded to the support surface 10A of the substrate 10 via the second submount 25, and the n-side electrode surface 30A is bonded to the first mounting surface 20B of the first submount 20. When no second submount 25 is provided, the p-side electrode surface 30B may be directly bonded to the support surface 10A of the substrate 10. By performing bonding in this manner, the external connection electrode 11 is electrically connected to the p-side electrode surface 30B, and the external connection electrode 12 is electrically connected to the n-side electrode surface 30A via the conductive member 40.

The laser diode 30 is bonded to the second submount 25 and in this state is indirectly mounted on the support surface 10A of the substrate 10. The laser diode 30 is located between the substrate 10 and the first submount 20. However, the laser diode 30 may be directly bonded to the support surface 10A without using the second submount 25. Thus, in the present embodiment, the second submount 25 is optionally employed. However, by using the second submount 25, heat dissipation can be improved. Also, advantageously, positional adjustment of the light-emitting point of the laser diode 30 in the height direction, in other words the Y-direction, can be relatively easily performed by adjusting the thickness of the second submount 25.

The conductive member 40 is a member formed of a metal such as gold, silver, copper, aluminum, or the like. The conductive member 40 may be shaped with the same thickness as the laser diode 30. The conductive member 40 has an upper surface facing the first mounting surface 20B of the first submount 20 and a lower surface located on a side opposite to the upper surface and bonded to the second mounting surface 25A. The conductive member 40 is, for example, a rectangular parallelepiped member but is not limited thereto, and may have other shape as long as having a lower surface that is bonded to the second mounting surface 25A.

The conductive member 40 is bonded to the first submount 20 and the second submount 25 and electrically connects the first wiring layer 21 and the second wiring layer 26. Specifically, the lower surface of the conductive member 40 is bonded to the second wiring layer 26 provided in the second mounting surface 25A. The upper surface of the conductive member 40 is bonded to the first wiring layer 21 on the first mounting surface 20B. The conductive member 40 may be bonded to the second wiring layer 26 and the first wiring layer 21 via the bonding portion. Thus, the n-side electrode surface 30A of the laser diode 30 is electrically connected to the first wiring layer 21 and the second wiring layer 26. Accordingly, the n-side electrode surface 30A can be electrically connected to the external connection electrode 12 disposed on the lower surface 10B of the substrate 10. According to this wiring example, a conventional wire bonding technique in which a wire made of gold or the like is drawn from the n-side electrode surface 30A to the second wiring layer 26 is not required, which can facilitate an operation of wiring, so that the manufacturing process can be simplified. However, the n-side electrode surface 30A and the second wiring layer 26 may be electrically connected by wire bonding without using the conductive member 40.

By aligning the height of the conductive member 40 in the Y-direction with the height of the laser diode 30, the first mounting surface 20B and the second mounting surface 25A can be parallel to each other and the operation of bonding the laser diode 30 and the conductive member 40 to the first submount 20 and the second submount 25, respectively, may be facilitated. The term "parallel" used here encompasses a tolerance of ±5 degrees.

In the present embodiment, the metal member 50 functions as a cap of the package that hermetically seals the space V in which the laser diode 30 is housed. An example of the metal member 50 is a metal foil. A thickness of the metal foil according to the present embodiment is approximately in a range of 10 µm to 300 µm. As the base material of the metal foil, for example, at least one selected from the group consisting of aluminum, copper, gold, Kovar, titanium, stainless steel, tungsten, beryllium copper, titanium, nickel, silver, platinum, nichrome, stainless steel, tantalum, molybdenum, and niobium or an alloy thereof is used.

For example, the base material is preferably covered with a metal film formed of at least one material selected from the group consisting of gold, platinum, titanium, nickel, chromium, palladium, and ruthenium. The metal film can be formed on the surface of the base material by a film forming process such as sputtering or plating, for example.

The heat dissipation member 60 illustrated in FIGS. 1 and 2 has a rectangular parallelepiped shape similarly to the first submount 20 or the second submount 25, but is not limited thereto. The heat dissipation member 60 may be formed of the same material as the material of the submounts described above. The heat dissipation member 60 is disposed above the first submount 20. In other words, the heat dissipation member 60 is located above the first submount 20. The heat dissipation member 60 has a lower surface 60B facing the first upper surface 20A of the first submount 20.

The metal member 50 is bonded to the first upper surface 20A of the first submount 20, the lower surface 60B of the heat dissipation member 60, and the second upper surface 15A of the lateral wall portion 15. The bonding can be performed using, for example, the same material and method as used to bond the lower surface 15B of the lateral wall portion 15 and the support surface 10A of the substrate 10 as described above.

The hermetic sealing structure using the metal member 50 is not limited to the example illustrated in FIGS. 1 and 2. The metal member 50 is bonded to the entire second upper surface 15A, but in another example may be bonded to a portion of the second upper surface 15A. Various hermetic sealing structures may be used as long as hermetic sealing can be achieved. In this specification, hermetic sealing refers to that the space V is sealed to such a degree that convection with the outside air is blocked. Hermetic sealing substantially reduces the degradation of a member disposed in the space V

In the present embodiment, the height from the support surface 10A to the first upper surface 20A of the first submount 20 is different from the height from the support surface 10A to the second upper surface 15A of the lateral wall portion 15. In the example illustrated in FIGS. 1 and 2, the height from the support surface 10A to the first upper surface 20A is greater than the height from the support surface 10A to the second upper surface 15A. The height difference between the first upper surface 20A and the second upper surface 15A may depend on manufacturing variations in the thicknesses of members such as the first submount 20, the second submount 25, and the lateral wall portion 15. The height difference in the present embodiment is in a range of approximately 100 µm to 300 µm, for example. The metal member 50 includes a deformation portion 51 attributed to the height difference. The deformation portion 51 may be a bent portion or a curved portion.

The metal member 50 includes a first portion 50A bonded to the heat dissipation member 60, a second portion 50B bonded to the second upper surface 15A, and a coupling portion 50C connecting the first portion 50A and the second portion 50B. The deformation portion 51 includes a first deformation portion 51A located at a boundary between the first portion 50A and the coupling portion 50C and a second deformation portion 51B located at a boundary between the second portion 50B and the coupling portion 50C.

As illustrated in FIGS. 1 and 2, at least a portion of the first portion 50A may be located between the heat dissipation member 60 and the first submount 20.

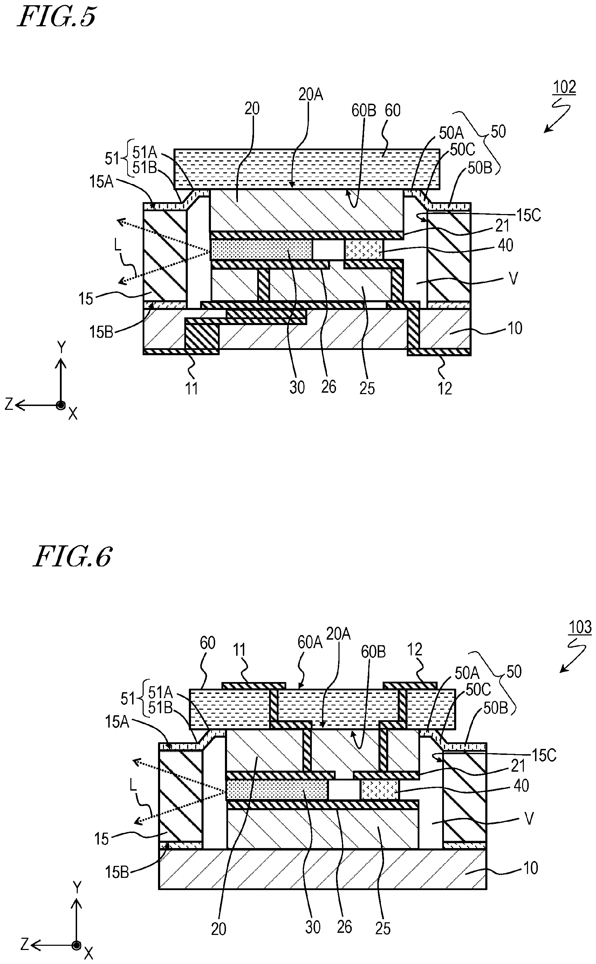

FIG. 5 is a cross-sectional view parallel to the YZ plane of a light source device 102. As illustrated in FIG. 5, the first portion 50A need not be formed between the heat dissipation member 60 and the first submount 20. In this case, the first portion 50A may be formed only in the peripheral region of the lower surface 60B of the heat dissipation member 60.

The heat dissipation member 60 is in thermal contact with the first submount 20 via or not via the first portion 50A of the metal member 50. Thus, the heat transferred from the laser diode 30 to the first submount 20 can be efficiently released to the outside by the heat dissipation member 60.

FIG. 6 is a cross-sectional view parallel to the YZ plane of a light source device 103 in which the external connection electrode 11 and the external connection electrode 12 are disposed on an upper surface 60A of the heat dissipation member 60. The external connection electrode 11 and/or the external connection electrode 12 can be disposed on the upper surface 60A. In the example illustrated in FIG. 6, the external connection electrode 11 and the external connection electrode 12 are provided on the upper surface 60A. Conductive wiring layers and via holes may be provided in the first submount 20 and the heat dissipation member 60, and each of the external connection electrode 11 and the external connection electrode 12 may be electrically connected to the first wiring layer 21. Alternatively, the external connection electrode 11 may be provided on the lower surface 10B of the substrate 10, and the external connection electrode 12 may be provided on the upper surface 60A of the heat dissipation member 60. In this case, the conductive member 40 may be omitted.

In the configuration example illustrated in FIG. 1, the external connection electrode 11 and/or the external connection electrode 12 can be provided on the upper surface 60A of the heat dissipation member 60 instead of the lower surface 10B of the substrate 10. In this case, punching or the like may be performed on the metal member 50 so that the first portion 50A of the metal member 50 located between the first submount 20 and the heat dissipation member 60 does not come into contact with the conductive wiring layer and cause a short circuit.

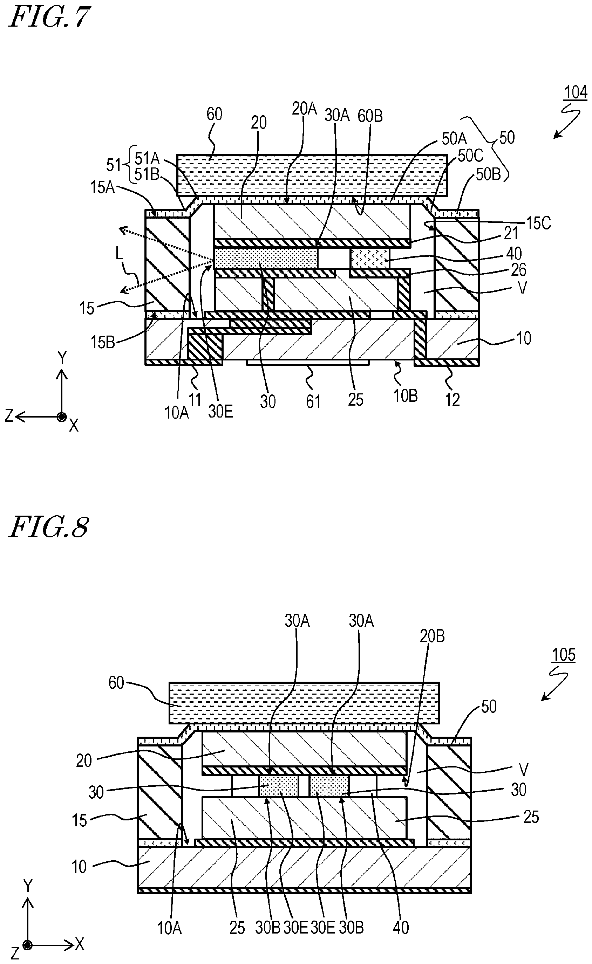

FIG. 7 is a cross-sectional view parallel to the YZ plane of a light source device 104 further including a heat dissipation member 61. As illustrated in the diagram, the light source device 104 may further include the heat dissipation member 61. The heat dissipation member 61 may be disposed on the lower surface 10B of the substrate 10. The heat dissipation member 61 may be formed of a material that is the same as or different from that of the heat dissipation member 60. As the heat dissipation member 61, for example, a plate-like member that is thinner than the heat dissipation member 60 may be used or a layer of a metal film may be formed by sputtering or the like. With the heat dissipation member 61, heat transferred to the second submount 25 can be efficiently released to the outside. As a result, a further heat dissipation effect can be obtained.

Reference is made to FIG. 3. In FIG. 3, the outer shape of the first upper surface 20A of the first submount 20 located inside the package is indicated by a broken line to facilitate understanding of the relative positional relationship between the first submount 20 and the heat dissipation member 60. Each of the first deformation portion 51A and the second deformation portion S 1B of the metal member 50 is indicated by a dashed line.

As illustrated in FIG. 3, the heat dissipation member 60 encloses the first submount 20 in a top plan view. In other words, the size of the heat dissipation member 60 in the XZ plane is larger than the size of the first submount 20 in the XZ plane. A portion of the heat dissipation member 60 may overlap a portion or the entirety of the second portion 50B. In the example illustrated in FIG. 3, the second portion 50B is an outermost region of the metal member 50. A portion of the second portion 50B partially overlaps the heat dissipation member 60. The region of the second portion 50B may include a region that does not overlap the heat dissipation member 60. With the heat dissipation member 60 having a size large enough to overlap a portion of or the entirety of the second portion 50B and being in thermal contact with the first submount 20, the heat dissipation of the light source device 100 can be further improved.

The first submount 20 includes first lateral surfaces 20S along an outer edge thereof. The heat dissipation member 60 includes second lateral surfaces 60S along an outer periphery thereof. In a top plan view, the first lateral surfaces 20S are positioned inward of the second lateral surfaces 60S. The first deformation portion 51A is located outward of the first lateral surfaces 20S and is located inward of the second lateral surfaces 60S. As described above, the first deformation portion 51Ais not in contact with a side (that is, an edge of the member) where the first upper surface 20A and the first lateral surface 20S of the first submount 20 are in contact with each other. Further, the first deformation portion 51A is not in contact with a side (that is, an edge of the member) where the lower surface 60B and the second lateral surface 60S of the heat dissipation member 60 are in contact with each other. By adjusting the position of the first deformation portion 51A such that the first deformation portion 51A of the metal member 50 is located in the above-described area, in other words, such that the first deformation portion 51A does not come into contact with an edge of the member, damage to the metal member 50 caused by the first deformation portion 51A coming into contact with an edge of the member can be reduced.

Thin metals such as foils can exhibit malleability (in particular, ductility). By using a ductile metal foil for the cap of the package, the height difference between the first upper surface 20A and the second upper surface 15A can be absorbed and damage to the metal member 50 due to thermal stress can be reduced. In addition, it is possible to reduce detachment of the metal member 50 from at least one of the first upper surface 20A of the first submount 20, the second upper surface 15A of the lateral wall portion 15, or the lower surface 60B of the heat dissipation member 60.

In particular, when a laser diode configured to emit blue or green light is used, preferably, the space V of the package is hermetically sealed. This is because the influence of dust accumulation caused by the laser light can be reduced by hermetic sealing. In a package requiring hermetic sealing, bonding on two opposite surfaces of the chip may be required in which both sides of a laser diode are bonded to a pair of submount members. In this case, it is difficult to achieve both hermetic sealing and bonding on two opposite surfaces of the chip. Specifically, it is required to hermetically seal the space V of the package while bonding both surfaces of the laser diode 30 such that the height of the second upper surface 15A from the support surface 10A matches the height of the first upper surface 20A. However, when bonding on two opposite surfaces of the chip is performed, for example, a load is applied to the bond portion. This load does not always result in uniform deformation of the bond portion. As a result, in addition to the above-described height difference in the dimensions of each member due to manufacturing variations, there may be a height difference between the first upper surface 20A and the second upper surface 15A due to the variation in the height of the bond portion. Thus, the amount of height difference that may occur may vary from manufacturing to manufacturing. This makes it difficult to achieve both hermetic sealing and bonding on two opposite surfaces of the chip.

According to the present embodiment, the height difference between the first upper surface 20A and the second upper surface 15A can be absorbed by using the metal member 50, including the deformation portion 51, as a cap for sealing the package. Accordingly, it is not necessary to precisely adjust the height of each member, so that the laser diode 30 can be easily bonded on both sides. Thus, a sealing structure that can achieve both hermetic sealing and bonding on two opposite surfaces of the chip is provided.

FIG. 8 is a cross-sectional view parallel to the XY plane of a light source device 105 including a plurality of the laser diodes 30. In the example illustrated in FIG. 8, the light source device 105 includes two laser diodes 30. The two laser diodes 30 each include the p-side electrode surface 30B and the n-side electrode surface 30A. The p-side electrode surface 30B of each laser diode 30 is bonded to the support surface 10A via the second submount 25, and the n-side electrode surface 30A is bonded to the first mounting surface 20B of the first submount 20.

The number of the laser diodes 30 included in the light source device 105 is not limited to two and may be three or more. The plurality of laser diodes 30 can emit light of different colors. For example, by installing three laser diodes configured to emit RGB light in a light source device, the light source device that emits white light is obtained. Alternatively, the plurality of laser diodes 30 may be configured to emit light of the same color. In this case, a light source device that can emit a high-power laser light can be obtained.

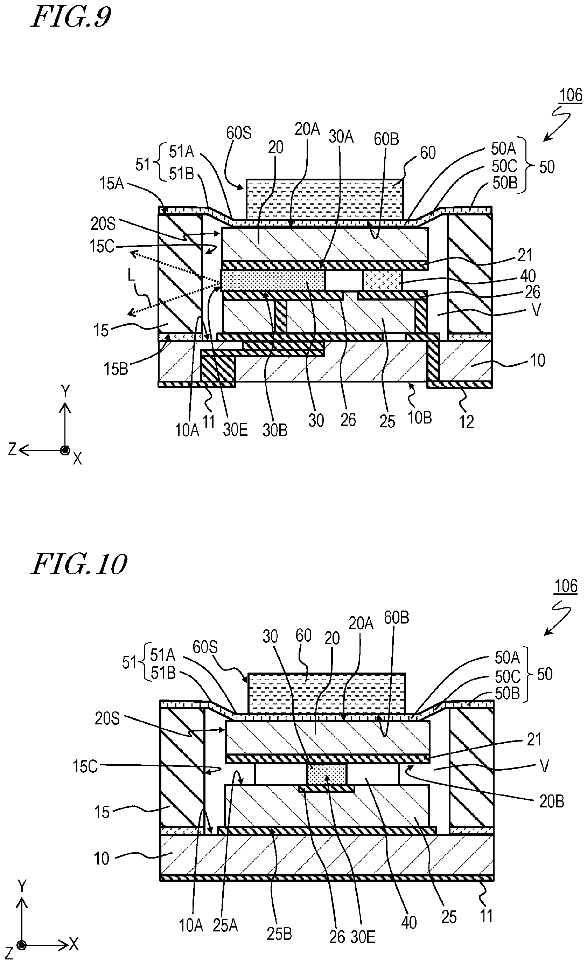

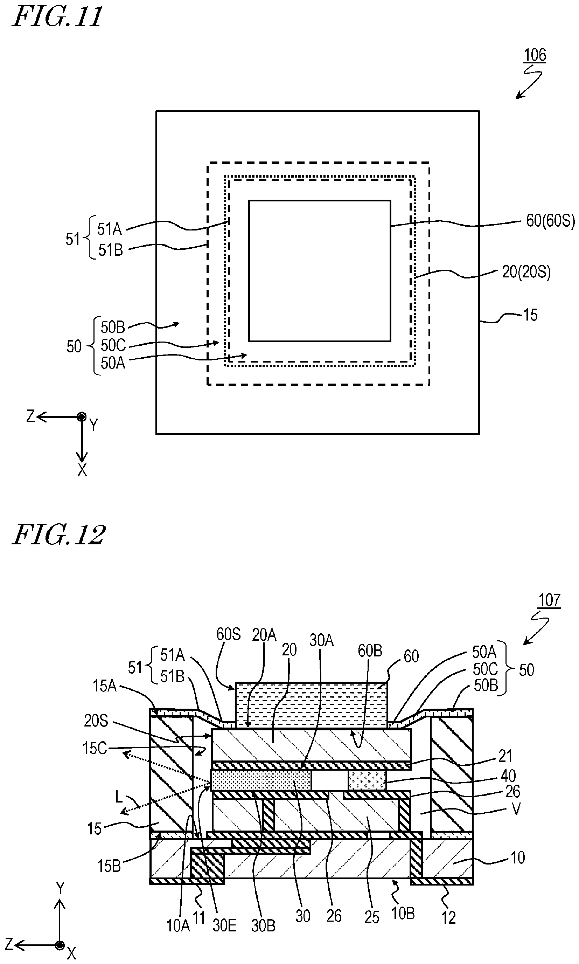

FIG. 9 is a cross-sectional view parallel to the YZ plane of a light source device 106. The cross section illustrated in FIG. 9 includes the cross section of the laser diode 30 and the conductive member 40. The laser light L emitted from the emission end surface 30E of the laser diode 30 in the Z-direction is indicated by a dashed line. FIG. 10 is a cross-sectional view parallel to the XY plane of the light source device 106. The cross section illustrated in FIG. 10 includes the emission end surface 30E of the laser diode 30. FIG. 11 is a plan view of the light source device 106 in a top plan view.

In the light source device 106 according to an embodiment of the present disclosure, the height from the support surface 10A to the first upper surface 20A is less than the height from the support surface 10A to the second upper surface 15A. Hereinafter, differences between the light source device 100 and the light source device 106 will be described.

In FIG. 11, the outer shape of the first upper surface 20A of the first submount 20 located inside the package is indicated by a broken line to facilitate understanding of the relative positional relationship between the first submount 20 and the heat dissipation member 60. Each of the first deformation portion 51A and the second deformation portion S 1B of the metal member 50 is indicated by a dashed line.

As illustrated in FIG. 11, the first submount 20 encloses the heat dissipation member 60 in a top plan view. In other words, the size of the first submount 20 in the XZ plane is larger than the size of the heat dissipation member 60 in the XZ plane.

In a top plan view, the second lateral surfaces 60S are positioned inward of the first lateral surfaces 20S. The first deformation portion 51A is located outward of the second lateral surfaces 60S and is located inward of the first lateral surfaces 20S. As in the light source device 100, the first deformation portion 51A is not in contact with a side (that is, an edge of the member) where the first upper surface 20A and the first lateral surface 20S of the first submount 20 are in contact with each other. Further, the first deformation portion 51A is not in contact with a side (that is, an edge of the member) where the lower surface 60B and the second lateral surface 60S of the heat dissipation member 60 are in contact with each other. By adjusting the position of the first deformation portion 51A such that the first deformation portion 51A of the metal member 50 is located in the above-described area, in other words, such that the first deformation portion 51A does not come into contact with an edge of the member, damage to the metal member 50 caused by the first deformation portion 51A coming into contact with the edge of the member can be reduced.

Also in the present embodiment, the height difference between the first upper surface 20A and the second upper surface 15A can be absorbed by using the metal member 50, including the deformation portion 51, as a cap for sealing the package. Accordingly, it is not necessary to precisely adjust the height of each member, so that the laser diode 30 can be easily bonded on both sides. Thus, a sealing structure that can achieve both hermetic sealing and bonding on two opposite surfaces of the chip is provided.

FIG. 12 is a cross-sectional view parallel to the YZ plane of a light source device 107. The metal member 50 need not be bonded to the lower surface 60B of the heat dissipation member 60. The metal member 50 does not include a portion located between the first submount 20 and the heat dissipation member 60 and may have a structure in which the metal member 50 is bonded to only the peripheral region of the first upper surface 20A of the first submount 20 and used for hermetic sealing.

Examples of a method of manufacturing the light source devices 100 to 107 according to the present embodiment will now be described. In the examples of the present method of manufacturing, a metal foil is used as the metal member 50.

### First Example of Method of Manufacturing

The laser diode 30 is mounted on the second submount 25 to prepare a light source unit.

The light source unit is bonded to the support surface 10A of the substrate 10, and the lateral wall portion 15 surrounding the light source unit is bonded to the support surface 10A. Separately from this process, the first submount 20 and the heat dissipation member 60 are bonded to the metal member 50 to prepare a cap unit for sealing the package. Lastly, the second portion 50B of the metal member 50 of the cap unit is bonded to the second upper surface 15A of the lateral wall portion 15, and the package provided with the light source unit and the lateral wall portion 15 is hermetically sealed by the cap unit. In this hermetic sealing, regardless of whether the first upper surface 20A is higher or lower than the second upper surface 15A, the height difference can be absorbed by the deformation of the metal foil.

### Second Example of Method of Manufacturing

The laser diode 30 is mounted on the second submount 25 to prepare a light source unit.

The light source unit is bonded to the support surface 10A of the substrate 10, and the lateral wall portion 15 surrounding the light source unit is bonded to the support surface 10A. The first submount 20 is bonded to the laser diode 30. The second portion 50B of the metal member 50 is bonded to the second upper surface 15A of the lateral wall portion 15, and the first portion 50A of the metal member 50 is bonded to the first upper surface 20A of the first submount 20 to hermetically seal the package provided with the light source unit and the lateral wall portion 15. Lastly, the heat dissipation member 60 is bonded to the metal member 50. In this manufacturing method also, regardless of whether the first upper surface 20A is higher or lower than the second upper surface 15A, the height difference can be absorbed by the deformation of the metal foil.

When the second portion 50B of the metal member 50 is bonded to the second upper surface 15A of the lateral wall portion 15, it is possible that a load is not applied to the entirety of the second upper surface 15A and the load is applied a limited area. For example, the metal member 50 may be bonded to the lateral wall portion 15 by laser welding in which a specific spot of the second upper surface 15A is irradiated with a laser light. This facilitates plastic deformation of the metal member (for example, metal foil) 50. As a result, the adhesion of the metal member 50 can be improved.

In the above-described manufacturing process, for example, a plurality of light source units and the lateral wall portions 15 each surrounding a respective one of the plurality of light source units are mounted on the substrate 10. Subsequently, the first submount 20, the metal member 50, and the heat dissipation member 60 are disposed. As in the first example of the method of manufacturing, cap units may be prepared and individually bonded to respective ones of the light source units. As in the second example of the method of manufacturing, the metal member 50 covering the lateral wall portion 15 may be provided after the first submount 20 is individually provided to each light source unit, and then the heat dissipation member 60 may be individually provided to the light source unit. Lastly, division into devices is performed by dicing or the like at positions in the lateral wall portion 15 between adjacent light source units, so that the plurality of light source devices 100 to 107 can be manufactured. In any of these method, division is performed with the metal member 50 and the lateral wall portion 15 bonded together and a hermetic seal formed, so that the hermetic sealing is maintained in each device after the division.

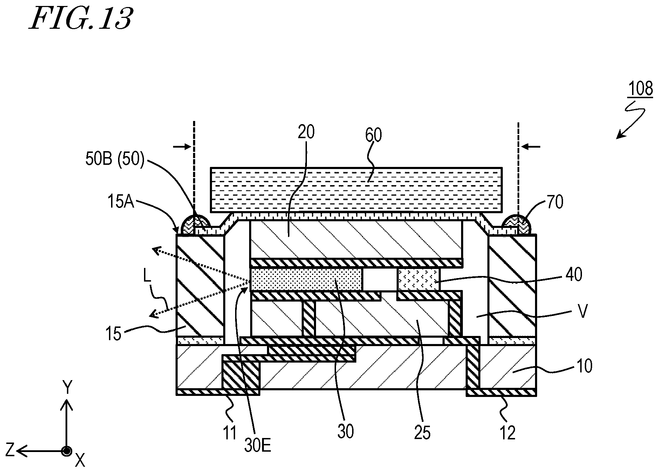

Referring to FIGS. 13 to 19, other examples of hermetic sealing structure using a metal member for improving hermeticity will be described.

FIG. 13 is a cross-sectional view parallel to the YZ plane of a light source device 108. The second portion 50B of the metal member 50 in the light source device 108 is located inward of the outer edge of the second upper surface 15A of the lateral wall portion 15 as indicated by an arrow in the diagram, and a portion of the second upper surface 15A is exposed. An adhesive member 70 is provided at the exposed portion of the second upper surface 15A, covering the end of the second portion 50B of the metal member 50. As the material of the adhesive member 70, a gold-tin or tin-silver-copper solder can be used. By using the adhesive member 70 as described above, the space V of the package can be hermetically sealed more reliably.

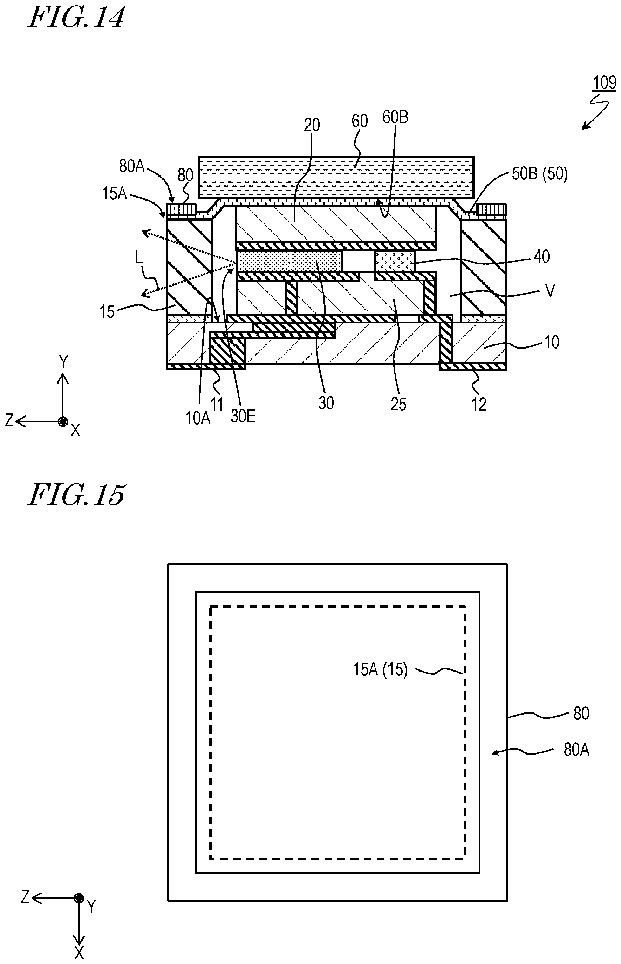

FIG. 14 is a cross-sectional view parallel to the YZ plane of a light source device 109. FIG. 15 is a plan view of a pressing member 80 in a top plan view as seen in the direction normal to the support surface 10A of the substrate 10. In FIG. 15, the inner edge of the second upper surface 15A of the lateral wall portion 15 is indicated by a dashed line for reference. The light source device 109 includes the pressing member 80 disposed on the upper surface of the second portion 50B of the metal member 50. The pressing member 80 illustrated in FIG. 15 has a rectangular ring shape continuously formed along the second upper surface 15A. The pressing member 80 may be formed of, for example, a material similar to that of the metal member 50 or a material such as a ceramic or glass. The pressing member 80 is bonded to the upper surface of the second portion 50B of the metal member 50 via the bonding member described above. Using a structure in which the second portion 50B of the metal member 50 is held between the pressing member 80 and the lateral wall portion 15 via a bonding member, the hermeticity can be improved.

The height from the support surface 10A to an upper surface 80A of the pressing member 80 is preferably less than the height from the support surface 10A to the lower surface 60B of the heat dissipation member 60. The pressing member 80 and the heat dissipation member 60 are not in contact with each other due to the height difference, so that the size of the heat dissipation member 60 can be increased in the XZ plane.

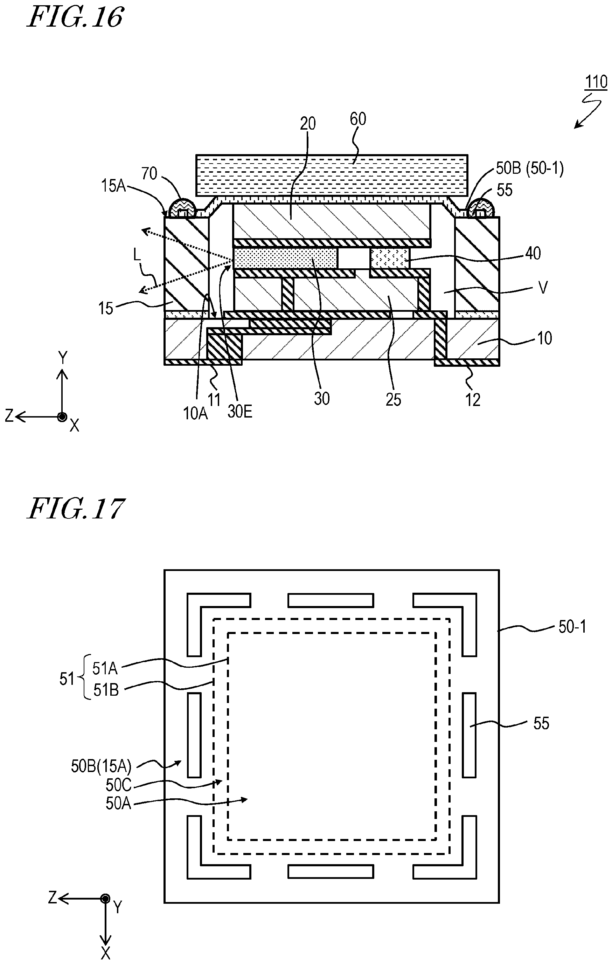

FIG. 16 is a cross-sectional view parallel to the YZ plane of a light source device 110. FIG. 17 is a plan view of a metal member 50-1 in a top plan view as seen in the direction normal to the support surface 10A of the substrate 10. The metal member 50-1 illustrated in FIG. 17 is different from the metal member 50 in including the second portion 50B that has a plurality of openings 55 non-continuously formed along and parallel to the second deformation portion 51B of the metal member 50-1. The openings 55 can be formed in the second portion 50B by punching, for example. The shape or pattern of the openings 55 illustrated in FIG. 17 is an example, and the openings 55 may have a different shape or pattern. By forming the openings in the metal member, the contact area between the second upper surface 15A of the lateral wall portion 15 and the adhesive member 70 is increased. Accordingly, the adhesion between the adhesive member 70 and the lateral wall portion 15 can be improved, and the hermeticity can be improved.

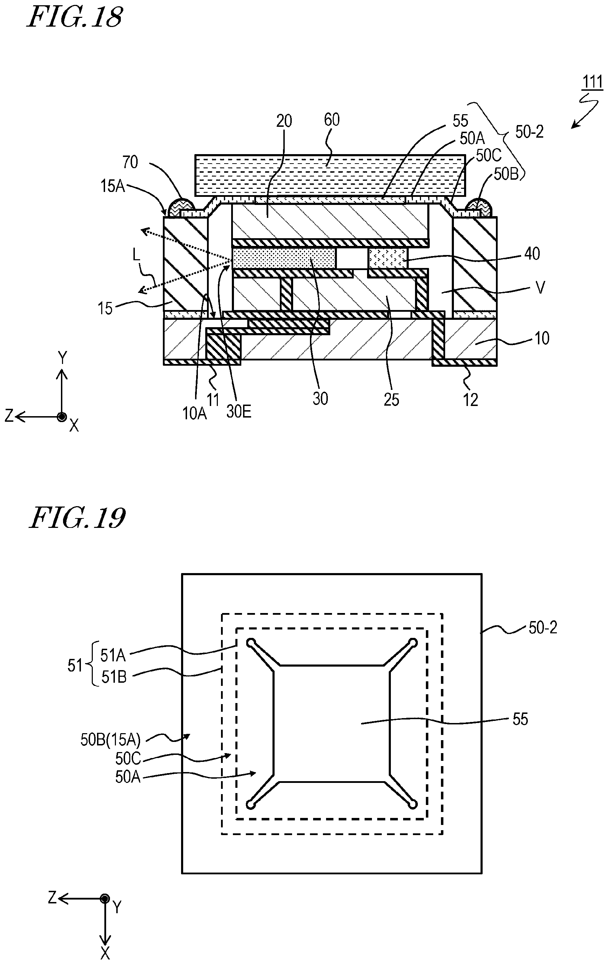

FIG. 18 is a cross-sectional view parallel to the YZ plane of a light source device 111. FIG. 19 is a plan view of a metal member 50-2 in a top plan view as seen in the direction normal to the support surface 10A of the substrate 10. The metal member 50-2 illustrated in FIG. 19 is different from the metal member 50 in including the first portion 50A in which the opening 55 is formed. The shape of the opening 55 illustrated in FIG. 19 is merely one example and may vary depending on design specifications or the like. With the opening 55 in the first portion 50A located at the central region of the metal member 50-2, twisting and wrinkling caused when the metal member is bent can be effectively reduced. The opening 55 illustrated in FIG. 18, which is located between the first submount 20 and the heat dissipation member 60, may be filled with a bonding member such as a gold-tin or tin-silver-copper solder. With such a structure, the bonding strength of the metal member can be improved. As in the metal member 50-1 described above, the metal member 50-2 may further have a plurality of openings in the second portion 50B.

### Second Embodiment

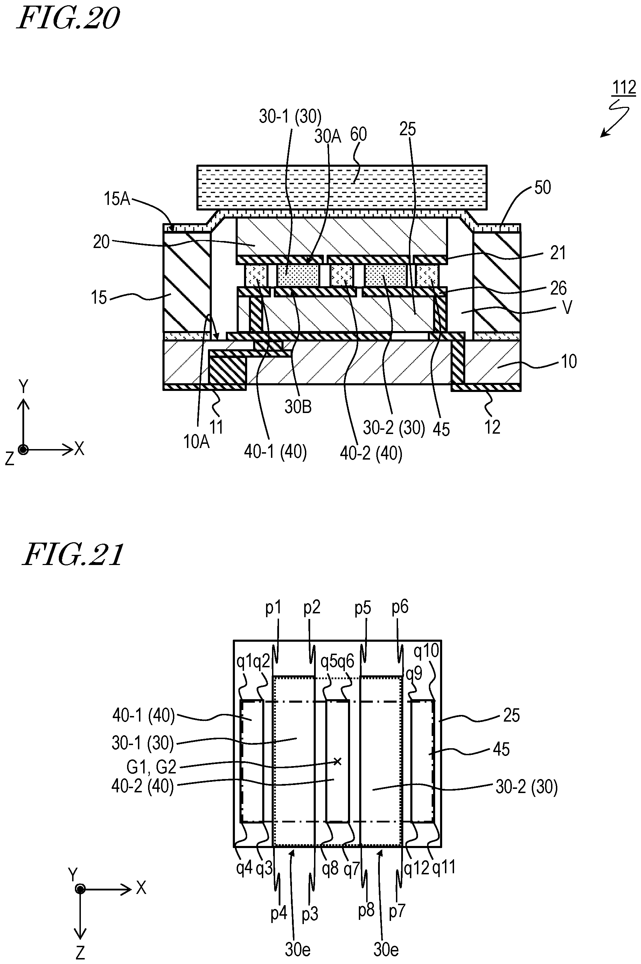

An example of the configuration of a light source device according to the second embodiment of the present disclosure will be described with reference to FIGS. 20 and 21.

The light source device according to the present embodiment includes a plurality of the laser diodes 30, a plurality of the conductive members 40, each corresponding to a respective one of the plurality of laser diodes 30, and one or more support members 45. That is, the total number of the conductive members 40 and the support members 45 is larger than the number of the laser diodes 30.

FIG. 20 is a cross-sectional view parallel to the XY plane of a light source device 112. FIG. 21 is a plan view of the second submount 25 in a state of supporting the two laser diodes 30, the two conductive members 40, and the one support member 45 in the top plan view as seen in the direction normal to the support surface 10A of the substrate 10. In the example illustrated in FIG. 20, the two conductive members 40-1 and 40-2, corresponding to the two laser diodes 30-1 and 30-2, and the one support member 45 are disposed between the first submount 20 and the second submount 25.

The two laser diodes 30-1 and 30-2 are arranged with the electrode surfaces of the same polarity facing the first wiring layer 21 side or the second wiring layer 26 side. For example, the n-side electrode surface 30A is bonded to the first wiring layer 21, and the p-side electrode surface 30B is bonded to the second wiring layer 26. In this case, the external connection electrode 11 is electrically connected to the n-side electrode surface 30A of the laser diode 30-1 via the conductive member 40-1, the p-side electrode surface 30B of the laser diode 30-1 is electrically connected to the n-side electrode surface 30A of the laser diode 30-2 via the conductive member 40-2, and the p-side electrode surface 30B of the laser diode 30-2 is electrically connected to the external connection electrode 12. That is, in this example, the external connection electrode 11, the laser diode 30-1, the laser diode 30-2, and the external connection electrode 12 are connected in series in this order via the two conductive members 40-1 and 40-2.

The support member 45 is a member that does not contribute to electrical conduction and may be formed of, for example, a metal, silicon, glass, a ceramic, or the same material as that of the substrate 10 described above. The support member 45 may be shaped with the same thickness as the laser diode 30. The support member 45 according to the present embodiment is a rectangular parallelepiped member having the same size as the conductive member 40, but is not limited to this shape. The lower surface of the support member 45 may be bonded to the second wiring layer 26 of the second submount 25 via a bonding portion, and the upper surface of the support member 45 may be bonded to the first wiring layer 21 of the first submount 20 via a bonding portion.

In the example illustrated in FIG. 21, the conductive member 40-1, the laser diode 30-1, the conductive member 40-2, the laser diode 30-2, and the support member 45 are aligned in this order at intervals in the X-direction. Each of the laser diode 30, the conductive member 40, and the support member 45 has a substantially rectangular outer shape in a top plan view. The outer shape of the laser diode 30-1 is formed by connecting apexes p1 to p4, and the outer shape of the laser diode 30-2 is formed by connecting apexes p5 to p8. Similarly, the outer shape of the conductive member 40-1 is formed by connecting apexes q1 to q4, the outer shape of the conductive member 40-2 is formed by connecting apexes q5 to q8, and the outer shape of the support member 45 is formed by connecting apexes q9 to q12. The long sides of the rectangular shape of each of the laser diode 30, the conductive member 40, and the support member 45 are parallel to the Z-direction, and the short sides of the rectangular shapes are parallel to the X-direction. The term "parallel" used herein may encompass a deviation of ±5 degrees.

In the example illustrated in FIG. 21, the first geometric figure formed by connecting the apexes p1 to p8 of the laser diode 30 is a rectangle, and the second geometric figure formed by connecting the apexes q1 to q12 of the conductive member 40 and the support member 45 is also a rectangle. In FIG. 21, the first geometric figure is indicated by a broken line, and the second geometric figure is indicated by a dot-dash line. The conductive member 40-1, the laser diode 30-1, the conductive member 40-2, the laser diode 30-2, and the support member 45 are disposed on the second submount 25 with a centroid G1 of the first geometric figure and a centroid G2 of the second geometric figure substantially coinciding with each other. The centers of the outer shapes of the laser diodes 30-1 and 30-2 are located inside the second geometric figure.

According to the present embodiment, by using the support member 45, it is possible to balance the load applied to the laser diode 30 and the conductive member 40 and/or the centroid of the cap unit when the cap unit is bonded to the lateral wall portion 15. In particular, when the centroid of the first geometric figure and the centroid of the second geometric figure substantially coincide with each other, it is possible to improve the stability at the time of performing bonding.

### Industrial Applicability

The light source devices according to the present disclosure are suitable for application as a light source in industrial fields where high-power laser sources are required, such as cutting, making holes, local heat treatment, surface treatment, metal welding, 3D printing, and the like for various materials.

### Denotation of Reference Numerals

10 Substrate
10A Support surface
10B Lower surface
11, 12 External connection electrode
15 Lateral wall portion
15A Second upper surface
15B Lower surface
15C Inner wall surface
20 First submount
20A First upper surface
20B First mounting surface
20S First lateral surface
21 First wiring layer
25 Second submount
25A Second mounting surface
25B Lower surface
26 Second wiring layer
30 Laser diode
30AN-side electrode surface
30B P-side electrode surface
30E Emission end surface
40 Conductive member
45 Support member
50 Metal member
50A First portion
50B Second portion
50C Coupling portion
51 Deformation portion
51A First deformation portion
51B Second deformation portion
55 Opening
60 Heat dissipation member
60B Lower surface
60S Second lateral surface
61 Heat dissipation member
70 Adhesive member
80 Pressing member
100 to 112 Light source device

## Claims

1. Alight source device comprising:
a substrate including a support surface;
a first submount including
a first mounting surface facing the support surface, and
a first upper surface located on a side opposite to the first mounting surface;
one or more laser diodes located between the substrate and the first submount and including a p-side electrode surface and an n-side electrode surface located on a side opposite to the p-side electrode surface;
a lateral wall portion disposed on the substrate, the lateral wall portion including a second upper surface and an inner wall surface, the inner wall surface defining a space in which the laser diode is housed;
a heat dissipation member disposed on the first submount; and
a metal member bonded to the heat dissipation member and the second upper surface and sealing the space, wherein
a height from the support surface to the first upper surface is different from a height from the support surface to the second upper surface, and
one of the p-side electrode surface or the n-side electrode surface is directly or indirectly bonded to the support surface and the other of the p-side electrode surface or the n-side electrode surface is bonded to the first mounting surface.

2. The light source device according to claim 1, wherein
the metal member is a metal foil, and
the metal foil includes a deformation portion.

3. The light source device according to claim 2, wherein
the metal foil includes a first portion bonded to the heat dissipation member, a second portion bonded to the second upper surface, and a coupling portion connecting the first portion and the second portion, and
the deformation portion includes a first deformation portion located at a boundary between the first portion and the coupling portion and a second deformation portion located at a boundary between the second portion and the coupling portion.

4. The light source device according to claim 3, wherein at least a portion of the first portion is located between the heat dissipation member and the first submount.

5. The light source device according to claim 4, wherein the height from the support surface to the first upper surface is greater than the height from the support surface to the second upper surface.

6. The light source device according to claim 5, wherein the heat dissipation member encloses the first submount in a top plan view as seen in a direction normal to the support surface.

7. The light source device according to claim 6, wherein a portion of the heat dissipation member overlaps a portion or an entirety of the second upper surface in the top plan view.

8. The light source device according to claim 6 or 7, wherein
the first submount includes first lateral surfaces along an outer periphery of the first submount,
the heat dissipation member includes second lateral surfaces along an outer periphery of the heat dissipation member, and
in the top plan view, with respect to the heat dissipation member, the first lateral surfaces of the first submount is located inward of the second lateral surfaces of the heat dissipation member, and
the first deformation portion is located outward of the first lateral surfaces and inward of the second lateral surfaces.

9. The light source device according to claim 4, wherein the height from the support surface to the first upper surface is less than the height from the support surface to the second upper surface.

10. The light source device according to claim 9, wherein the first submount encloses the heat dissipation member in a top plan view as seen in a direction normal to the support surface.

11. The light source device according to claim 10, wherein
the first submount includes first lateral surfaces along an outer periphery of the first submount,
the heat dissipation member includes second lateral surfaces along an outer periphery of the heat dissipation member, and
in the top plan view,
with respect to the first submount, the second lateral surfaces of the heat dissipation member is located inward of the first lateral surfaces of the first submount, and
the first deformation portion is located outward of the second lateral surfaces and inward of the first lateral surfaces.

12. The light source device according to any one of claims 2 to 11, wherein
the metal foil includes a base material and a metal film covering the base material, the base material is at least one selected from the group consisting of aluminum, copper, gold, Kovar, titanium, stainless steel, tungsten, beryllium copper, titanium, nickel, silver, platinum, nichrome, stainless steel, tantalum, molybdenum, and niobium or an alloy thereof, and
the metal film is formed of at least one selected from the group consisting of gold, platinum, titanium, nickel, chromium, palladium, and ruthenium.

13. The light source device according to any one of claims 1 to 12, further comprising:
a second submount including
a lower surface bonded to the support surface, and
a second mounting surface where the laser diode is disposed, the second mounting surface being located on an opposite side to the lower surface, wherein
the laser diode is bonded to the support surface via the second submount.

14. The light source device according to claim 13, wherein
the first submount comprises a first wiring layer electrically connected to the other of the p-side electrode surface or the n-side electrode surface, and
the second submount includes a second wiring layer electrically connected to the one of the p-side electrode surface or the n-side electrode surface.

15. The light source device according to claim 14, further comprising a conductive member bonded to the first submount and the second submount and electrically connecting the first wiring layer and the second wiring layer.
